# EUROPÄISCHE PATENTSCHRIFT

(11) **EP 3 715 893 B1**
(45) Veröffentlichungstag und Bekanntmachung des Hinweises auf die Patenterteilung: **24.02.2021**
(21) Anmeldenummer: 19164940.9
(22) Anmeldetag: 25.03.2019
(51) Int. Cl.: G01R 33/30, G01R 33/31

(54) **NMR-SPEKTROMETER MIT SCHNELLWECHSELSYSTEM FÜR PROBEN**
NMR SPECTROMETER WITH QUICK SWAP SYSTEM FOR SAMPLES
SPECTROMÈTRE RMN POURVU DE SYSTÈME DE CHANGEMENT RAPIDE POUR ÉCHANTILLONS

(43) Veröffentlichungstag der Anmeldung: 30.09.2020
(73) Patentinhaber: Bruker Switzerland AG, 8117 Fällanden (CH)
(72) Erfinder: Meister, Roger, 8132 Hinteregg (CH); Schmid, Reto, 8409 Winterthur (CH); Sieber, Sven, 8607 Seegräben (CH)
(74) Vertreter: Kohler Schmid Möbus Patentanwälte

(56) Entgegenhaltungen:
- DE-B4-102004 029 633
- Frank Schumann: "NMR in Automation, Tools & Tricks", NMR Benutzertagung, 2016, Seiten 1-29, XP055618381, Internet Gefunden im Internet: URL:https://www.bruker.com/fileadmin/user_ upload/5-Events/User_Meetings/UM_GERMAN/Do wnloads/D2_NMR_automation_Tools_Tricks_Fra nk_Schumann.pdf [gefunden am 2019-09-04]

## Beschreibung

Die Erfindung betrifft ein NMR-Spektrometer mit einem NMR-Magnetsystem, das eine Bohrung durch das Magnetzentrum zum Einführen einer NMR-Messprobe in einem Transportbehälter aufweist, sowie mit einer Transportvorrichtung zur pneumatischen Beförderung der NMR-Messprobe durch einen Transportkanal in das NMR-Magnetsystem hinein und aus dem NMR-Magnetsystem heraus, wobei die Transportvorrichtung eine mechanische Schnittstelle umfasst, an der ein Wechselsystem montiert ist, welches mindestens eine Parkaufnahme zum Zwischenspeichern eines Transportbehälters aufweist, wobei die Parkaufnahme in einer Transportposition zur Beladung mit einem Transportbehälter in den Transportkanal eingebracht, zum Zwischenspeichern des Transportbehälters aus dem Transportkanal entfernt und zum Weitertransport des Transportbehälters wieder in den Transportkanal eingebracht werden kann.

Ein solches NMR-Spektrometer -wie sie bereits seit vielen Jahren von der Anmelderin hergestellt und vertrieben werden- ist beschrieben in der DE 10 2004 029 633 B4 (=Referenz [1]).

### Hintergrund der Erfindung

Eine Transportvorrichtung zur pneumatischen Beförderung der NMR-Messproben ist bekannt aus der Firmenbroschüre "Bruker Sample Transport. BST Installation and Technical Manual Version 002" der Bruker BioSpin AG vom 21. November 2008 (=Referenz [2]), insbesondere aus den Kapiteln 2, 3 und 5.7 - 5.9 dieser Publikation. Im Folgenden wird eine derartige Transportvorrichtung mit "BST" abgekürzt.

Zur schnellen und exakten Analyse der chemischen Zusammensetzung von Messproben oder zur Strukturbestimmung von in den Proben enthaltenen Stoffen werden seit über einem halben Jahrhundert NMR-Verfahren eingesetzt. Diese können in NMR-Spektrometern durchgeführt werden. Für diese Zwecke geeignete NMR-Spektrometer sind beispielsweise in der EP 2 199 816 B1 (=Referenz [3]) beschrieben.

Die NMR-Spektroskopie ist ein leistungsfähiges Verfahren der instrumentellen Analytik. Bei diesen NMR-Verfahren ist die Probe einem starken statischen Magnetfeld B₀ in einer z-Richtung ausgesetzt. Dabei kommt es zu einer Wechselwirkung mit den Kernspins des Probenmaterials, insbesondere zur Ausrichtung von Kernspins in der Messsubstanz. Sodann werden dazu orthogonale hochfrequente elektromagnetische Impulse in x- oder y-Richtung in die Probe eingestrahlt. Die zeitliche Entwicklung dieser Kernspins der Probe erzeugt wiederum hochfrequente elektromagnetische Felder, welche in der NMR-Apparatur detektiert werden. Aus den detektierten HF-Feldern können Informationen über die Eigenschaften der Probe integral über einen gewissen räumlichen Bereich erhalten werden. Insbesondere kann aus der Lage und Intensität von NMR-Linien auf die chemische Zusammensetzung sowie die chemischen Bindungsverhältnisse in der Probe geschlossen werden.

Die Messprobe besteht in der Regel aus einem zylindrischen Probenröhrchen mit üblicherweise kreisrundem, ovalem oder rechteckigem Querschnitt, welches die feste oder flüssige Messsubstanz enthält. Das Probenröhrchen ist mindestens auf der Seite verschlossen, mit der es zuerst in den Probenkopf eindringt, und befindet sich typischerweise in einem Spinner. Probenröhrchen und Spinner werden mit Hilfe der Transportvorrichtung von außerhalb des Magneten in den Probenkopf transportiert. Die DE 37 29 819 C2 (=Referenz [4]) beschreibt eine Transportvorrichtung zum Befördern eines Transportgutes zwischen einem Eingabepunkt, an dem das Transportgut in die Transportvorrichtung eingesetzt und entnommen werden kann, und einem Zuführungspunkt, an dem das Transportgut einer Raumtemperaturbohrung eines Kryostaten zugeführt werden kann, wobei das Transportgut eine NMR Messprobe und einen Probenhalter umfasst, wobei der Eingabepunkt zum Zuführungspunkt sowohl horizontal als auch vertikal beabstandet ist, und wobei ein Transportrohr zum pneumatischen Befördern des Transportgutes innerhalb des Transportrohrs von einem ersten Transferpunkt am unteren Ende des Transportrohrs zu einem zweiten Transferpunkt am oberen Ende des Transportrohrs vorgesehen ist.

Im Folgenden wird davon ausgegangen, dass sich eine Zuführungsöffnung oben am Probenkopf befindet und das Probenröhrchen von oben in den Probenkopf eingeführt wird. Es ist jedoch auch denkbar, das Probenröhrchen von unten in eine dafür vorgesehene Öffnung in den Probenkopf einzuführen. Dieser Fall ist analog zum oben genannten und soll aus Gründen der Übersichtlichkeit hier nicht näher beschrieben werden. Wenn sich das Probenröhrchen in der Messposition befindet, dann befindet sich der Spinner innerhalb einer Turbine. Die Turbine ermöglicht eine Rotation des Probenröhrchens (siehe etwa DE 10 2013 212 312 B4 = Referenz [5]).

Damit eine möglichst kurze Totzeit zwischen zwei aufeinanderfolgenden Messungen für das NMR-System entsteht, sollte eine im Magnetzentrum bereits vermessene Messprobe so schnell wie möglich gegen eine neue, noch zu vermessende Probe ausgewechselt werden können.

Mit den heute erhältlichen Systemen wird eine Messprobe aus dem Magnetzentrum durch eine Transportvorrichtung zur Oberseite des NMR-Spektrometers transportiert und von dort durch ein Automationssystem wegbefördert. Dieses Automationssystem legt die bereits vermessene Messprobe in einem Magazin ab und nimmt eine weitere, in der Regel noch unvermessene Messprobe auf, die es dann wieder zur Transportvorrichtung befördert, von wo sie durch die Transportvorrichtung wiederum in das Magnetzentrum zur NMR-Messung gelangt. Es ist weiterhin möglich, eine Mehrzahl Messproben in einer Vorheiz- oder Kühlstation außerhalb des NMR-Spektrometers bereits auf einer gewünschten Messtemperatur vorzuhalten. Diese Vorgehensweise hat zwei Nachteile: Zum einen muss das NMR-Spektrometer auf das Automationssystem so lange warten, bis letzteres die neue Messprobe bereitgestellt hat. Zum anderen sind die Messproben durch den relativ langen Transportweg zwischen Vorheiz- oder Kühlstation und Messposition im NMR-Spektrometer nicht (beziehungsweise nicht mehr) auf einer spezifischen, für die NMR-Messung wünschenswerten Temperatur.

Ein automatisiertes, kompaktes und zur Probentemperierung ausgerüstetes Schnellwechselsystem wäre daher für alle derartigen NMR-Spektrometer von großem Vorteil.

Die Vorrichtung nach Referenz [1] beschreibt ein Schnellwechselsystem mit einem -in einigem räumlichen Abstand außerhalb des NMR-Spektrometers angeordneten- Magazin in welchem eine Vielzahl von Probenträgern aufgenommen werden kann, wobei die jeweils nächste zu vermessende Probe über eine Zuführungsleitung in die Messposition im NMR-Spektrometer pneumatisch transportiert und nach der Messung dann über eine separate Rückführungsleitung wieder in das Magazin zurückbefördert wird. Die Verbindung zwischen Magazin und Spektrometer, also der Zuführ- oder der Rückführ-Weg, wird mittels zweier Weicheneinrichtungen ausgewählt, die in von den beiden Leitungen gemeinsam genutzten Abschnitten am Anfang sowie am Ende der Leitungen positioniert sind.

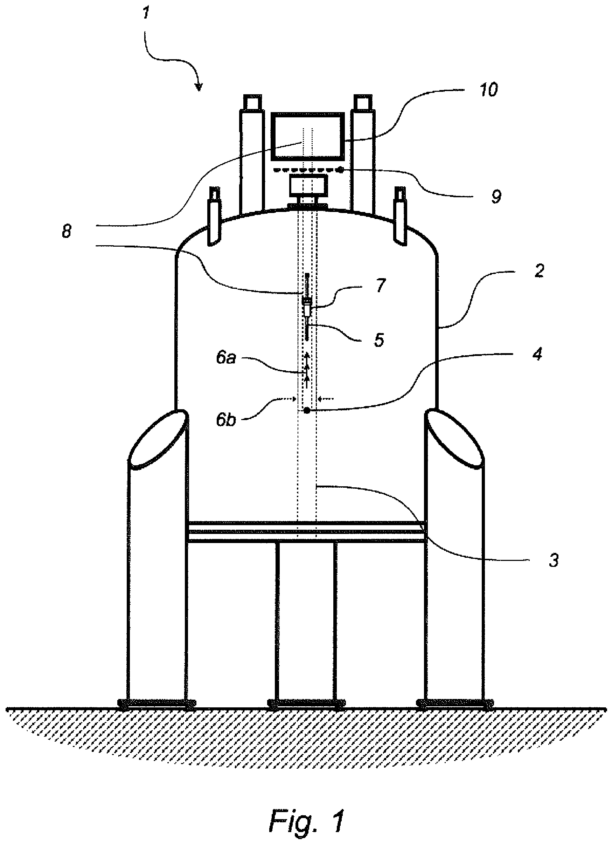

In der Zuführungsleitung ist -ebenfalls in räumlichem Abstand außerhalb des NMR-Spektrometers vorzugsweise im magnetischen Streufeld der NMR-Apparatur und zwischen den beiden Weichen angeordnet- eine beheizbare Parkposition vorgesehen, in welcher Probengefäße zwischengespeichert und temperiert werden können. Gemäß der Figur 1 in Referenz [1] ist die Parkposition zwischen Magazin und NMR-System waagerecht angeordnet.

Das Magazin ist auch bereits automatisierbar zu betreiben, da es mit einer programmierbaren Wählvorrichtung für Probengefäße ausgestattet sein kann.

Allerdings sind auch bei der NMR-Apparatur nach Referenz [1] relativ lange konstruktionsbedingte Transportwege der temperierten Messproben aus der Parkposition bis zum Magnetzentrum des Spektrometers und damit entsprechende lange Wartezeiten nicht zu vermeiden, sodass sich die jeweilige Probe dann zu Beginn der NMR-Messung oftmals nicht mehr auf ihrer optimalen Temperatur befindet und andererseits auch ein schneller Wechsel und mithin ein hoher Durchsatz der Proben erheblich "abgebremst" wird. Durch die bei der Apparatur nach Referenz [1] vorgesehenen Weichen ist zudem ein noch weiter verlängerter Verfahrweg der Proben erforderlich, was die "Reisezeit" wiederum weiter erhöht. Weiterhin umfasst das Transportsystem von Referenz [1] zwei Transportleitungen zur Zuführung bzw. Rückführung der Probe sowie Weichen zum Umschalten zwischen den Transportleitungen. Die Zuführungsleitung ist zudem durch die Parkposition unterbrochen und wird seitlich versetzt in Richtung des NMR-Systems fortgesetzt.

### Aufgabe der Erfindung

Der vorliegenden Erfindung liegt demgegenüber die Aufgabe zugrunde, ein NMR-Spektrometer der eingangs definierten Art mit möglichst einfachen technischen Maßnahmen so zu modifizieren, dass die oben aufgezählten Nachteile vollständig oder zumindest weitestgehend vermieden werden, ohne damit eine Minderung der Qualität der NMR-Messungen hervorzurufen, wobei die NMR-Apparatur besonders kompakt sein soll und etwaige zusätzliche Materialkosten sowie weiterer Fertigungsaufwand unerheblich bleiben.

Eine weitere Aufgabe der vorliegenden Erfindung besteht darin, ein schnelleres, automatisiertes Wechseln der Messproben zu ermöglichen, um kurze Messzykluszeiten zu erreichen. Die Erfindung soll außerdem problemlos eine wirksame und schnelle Vortemperierung der Messproben möglich machen, so dass ein NMR-Experiment direkt nach dem Transport der jeweiligen Messprobe in das Magnetzentrum sofort und ohne weitere Vorbereitungszeit gestartet werden kann und mithin die Durchlaufzeiten signifikant verkürzt werden.

### Kurze Beschreibung der Erfindung

Diese komplexe Aufgabe wird auf ebenso überraschend einfache wie wirkungsvolle Weise dadurch gelöst, dass bei einem gattungsgemäßen NMR-Spektrometer mit den eingangs definierten Merkmalen das Wechselsystem derart modifiziert ist, dass die Parkaufnahme in der Transportposition einen Teil des Transportkanals bildet.

Das erfindungsgemäß modifizierte NMR-Spektrometer benötigt zur Be- und Entladung der Messproben keine Weiche, wie sie etwa in der Anordnung nach Referenz [1] zwingend erforderlich ist. Dadurch wird der Verfahr-Weg jeder einzelnen Messprobe deutlich reduziert. Die Weichenfunktion ist jetzt im Wechselsystem integriert, was zudem auch Platz einspart.

Die Zu- und Wegführung jeder Messprobe erfolgt immer durch den gleichen Transportkanal. Es wird lediglich die entsprechende Parkaufnahme im Wechselsystem hin- und hergeschoben. Im Gegensatz dazu sind in der Anordnung nach Referenz [1] immer zwei verschiedene Transportwege vorgesehen, auf welchen das Zentrum des NMR-Magnetsystems mit einer neuen Messprobe beladen und nach der Messung die Messprobe wieder entladen wird.

Weil die Parkaufnahme in der Transportposition einen Teil des Transportkanals bildet, weist die erfindungsgemäße Transportvorrichtung -ganz anders als die bisher üblichen Ausführungen, wie etwa nach Referenz [1]- ein direkt an der mechanischen Schnittstelle zu externen Geräten des NMR-Spektrometers montiertes Wechselsystem mit einem oder mehreren Parkaufnahmen auf, in denen eine Messprobe mit einem Transportbehälter parkiert werden können. Die Transportvorrichtung ist direkt auf dem offenen Ende der Magnetbohrung und die mechanische Schnittstelle sowie das Wechselsystem mit einem geringen Abstand von etwa 50mm bis 200mm, vorzugsweise ungefähr 80mm über dem offenen Ende der Bohrung angekoppelt. Somit ist ein Wechsel einer Messprobe viel schneller möglich als bisher mit den bekannten Systemen.

In der jeweiligen Parkstellung der Parkaufnahmen können die Messproben während ihrer Parkdauer je nach Bedarf außerdem auch zusätzlich noch individuell und damit optimal temperiert werden, bevor sie -auf kürzestem Wege- aus ihrer Parkaufnahme zur NMR-Messung in das Zentrum des Magnetsystems befördert werden.

Gerade aufgrund der durch die Erfindung eröffneten Möglichkeiten einer solchen automatisierten Schnellzuführung von -idealerweise sogar individuell vortemperierten- NMR-Messproben ist es jetzt möglich, den NMR-Messzyklus sehr kurz zu halten, da ein Vortemperieren und weitere vorgeschaltete Prozesse problemlos ausgelagert werden können und somit nicht mehr den NMR-Messzyklus -unnötig- verlängern. Das schnelle Temperieren ermöglicht kürzere Durchlaufzeiten was ein wesentlicher ökonomischer Faktor bei der Messung großer Anzahlen von NMR-Messproben ist. Gerade durch diese zeitliche Verkürzung des Messzyklus ergeben sich durch die Erfindung hohe wirtschaftliche Vorteile für den Nutzer des NMR-Spektrometers, da wesentlich mehr Messungen in der gleichen Zeit durchgeführt werden können.

An dieser Stelle sei ausdrücklich darauf hingewiesen, dass sich die Vorteile der Erfindung nicht nur bei vertikalen NMR-Spektrometern, sondern ebenso auch bei NMR-Systemen mit horizontaler oder schräg liegender z-Achse erzielen lassen. Die angegebenen axialen Positionen müssen dann nicht mehr notwendig "oberhalb" beziehungsweise "unterhalb" des NMR-Magnetspulensystems liegen, sondern gegebenenfalls auch "rechts" oder "links" neben demselben. Jedenfalls spielt die Schwerkraft bei der Wirkungsweise der vorliegenden Erfindung zumindest bei NMR-Messungen von Feststoffen eine untergeordnete Rolle.

### Bevorzugte Ausführungsformen der Erfindung

Für die Automatisierung des Probentransports wird das erfindungsgemäße NMR-Spektrometer in der Regel an der Schnittstelle und/oder im Wechselsystem sowie möglicherweise auch in der Bohrung des NMR-Magnetsystems eine oder mehrere Sensoreinrichtungen zur aktuellen Erkennung eines Transportbehälters aufweisen.

Bei einer bevorzugten Klasse von Ausführungsformen der Erfindung weist das Wechselsystem einen Sperrmechanismus auf, welcher die Durchführung des Transportbehälters in das NMR-Magnetsystem entweder absperren oder freigeben kann. Denkbar ist auch die Ausführung einer Parkaufnahme mit einem festen Sperrmechanismus. Durch diesen wird ein Transportbehälter bei der Einführung in das NMR-Magnetsystem aufgefangen. Die Weiterleitung in die Messposition kann je nach Ausgestaltung des Probenbehälters auf unterschiedliche Weise erfolgen. So ist für allseitig geschlossene Transportbehälter eine rotierbare Parkaufnahme möglich, die innerhalb des Wechselsystems so rotiert wird, dass sie für die Weiterleitung des Transportbehälters um 180° rotiert in die Transportposition eingebracht wird und somit wieder einen Teil des Transportkanals bildet.

Bevorzugt ist jedoch ein Sperrmechanismus, der die Durchführung des Transportbehälters in das NMR-Magnetsystem entweder absperren oder freigeben kann. Um den Transportbehälter während der Parkdauer und in der Parkstellung innerhalb der Parkaufnahme sicher festzuhalten, wird der Transportbehälter mittels des Sperrmechanismus im Inneren der Parkaufnahme fixiert. Für den späteren pneumatischen Weitertransport der Messprobe zur NMR-Messung über den Transportkanal in den Messbereich des Magnetsystems hinein gibt der Sperrmechanismus dann den Transportbehälter frei, sobald sich die Parkaufnahme in der Transportposition befindet, so dass der Transportbehälter durch den Transportkanal in den Magneten bewegt werden kann.

Eine besonders vorteilhafte Weiterbildung dieser Ausführungsformen zeichnet sich dadurch aus, dass die mindestens eine Parkaufnahme Sperröffnungen zum Durchgriff des Sperrmechanismus auf den Transportbehälter der Parkaufnahme aufweist.

Schon aus Platzgründen ist es wohl mechanisch am einfachsten, den Sperrmechanismus seitlich durch die Wand der Parkaufnahme hindurch über Sperröffnungen auf den Transportbehälter einwirken zu lassen. Denkbar sind allerdings auch andere Lösungen, etwa ein Eingriff des Sperrmechanismus auf den Transportbehälter durch eine obere oder untere Öffnung der Parkaufnahme, durch welche der Transportbehälter in die Parkaufnahme hinein und später wieder herausbewegt werden kann.

Bei einer bevorzugten Variante dieser Weiterbildung weist die mindestens eine Parkaufnahme Sperröffnungen zum Durchgriff des Sperrmechanismus auf den Transportbehälter der Parkaufnahme auf.

Jede Parkaufnahme besitzt ihren eigenen Sperrmechanismus, welcher somit Teil der Parkaufnahme ist. Die spezielle Ausbildung des Sperrmechanismus als System von -seitlich durch die Sperröffnungen auf den Transportbehälter einwirkenden- Sperrstiften dürfte eine konstruktiv besonders einfache und sicher wirkende Lösung darstellen.

Bevorzugt sind auch Ausführungsformen des erfindungsgemäßen NMR-Spektrometers, bei welchen das Wechselsystem zum Transport eines Transportbehälters aus dem NMR-Magnetsystem heraus und durch das Wechselsystem hindurch eine azimutal geschlossene, an ihren axialen Enden jeweils offene Durchgangsröhre umfasst, die in die Transportposition eingebracht werden kann.

Die Durchgangsröhre dient dem direkten pneumatischen Rücktransport einer im Messbereich des Magnetsystems bereits vermessenen Probe aus dem Magneten heraus durch das Wechselsystem hindurch und nach außerhalb des Spektrometers. Dazu wird die Durchgangsröhre in den Ausschnitt des Transportkanals geschoben, in welchem zu anderen Zeiten -auf der Transportposition- eine Parkaufnahme zur Übernahme einer neuen Messprobe oder zu deren Weitergabe in das Magnetzentrum sitzen kann. Da die Durchgangsröhre azimutal geschlossen ist, entweicht dem pneumatischen Antriebssystem der Transportvorrichtung weniger Druck. Ebenfalls wird die Durchgangsröhre bevorzugt verwendet, wenn keine Temperierung der NMR-Messprobe und/oder kein hoher Probendurchsatz mit dem NMR-Spektrometer erforderlich ist.

Je nach speziellem Einsatzzweck können Ausführungsformen des erfindungsgemäßen NMR-Spektrometers von besonders hohem Nutzen sein, bei denen das Wechselsystem eine Vielzahl von, vorzugsweise bis zu zwölf, Parkaufnahmen enthält.

Dies kann von Vorteil sein, wenn die Aufheiz- (oder Abkühl-) Zeit einer Messprobe länger ist, als die Zeit der eigentlichen NMR-Messung. Zusätzlich kann bei einem gleichzeitigen Aufheizen oder Abkühlen in der Parkstellung der Parkaufnahme der Temperiervorgang langsam und damit äußerst schonend für die Proben-substanz erfolgen. Weiter kann eine verlängerte Temperierdauer, unabhängig von der NMR-Messzeit, gewünscht werden, um damit allfällige chemische oder biologische Prozesse in der Messprobe zu kontrollieren. Falls die Messung nur sehr kurz ist, und damit eventuell das Hauptwechselsystem zu langsam ist, um das hier vorliegende Wechselsystem zu befüllen, kann mit mehreren Positionen wenigstens batchweise schnelle Messungen durchgeführt werden. Mit mehreren Parkaufnahmen hat man länger Zeit, um eine einzelne Probe aufzuheizen. Die Temperatur, respektive die Größe der Temperaturänderung kann darum sehr moderat eingestellt werden, was bei einigen Proben von Vorteil ist. Damit können außerdem mehrere Proben auf verschiedenen Temperaturen gehalten werden.

Ein gemäß dieser Ausführungsformen gestaltetes Wechselsystem kann modifiziert werden durch einen beweglichen, insbesondere linear verschiebbaren oder drehbaren Schlitten, welcher eine der Parkaufnahmen und eine Durchgangsbohrung trägt, die in der Transportposition einen Teil des Transportkanals bildet. Vorzugsweise umfasst der Schlitten mindestens einen Sperrmechanismus der oben beschriebenen Art pro Parkaufnahme.

Ganz besonders bevorzugt ist daher eine Klasse von Ausführungsformen des erfindungsgemäßen NMR-Spektrometers, bei welchen das Wechselsystem eine Temperiereinrichtung aufweist, mittels der ein in dieser Parkaufnahme zwischengespeicherter Transportbehälter, insbesondere die NMR-Messprobe im Transportbehälter, beheizbar und/oder kühlbar ist. In der Vorrichtung nach Referenz [1] beispielsweise ist eine Kühlung der Proben in der Parkposition nicht möglich, sondern allenfalls in einem Kälteschrank, in welchem das Magazin untergebracht sein kann. Hiermit lässt sich direkt in dem Wechselsystem, wahlweise auch jeweils nur für eine Parkaufnahme, eine Termperierung der NMS-Messprobe nahe an der Messposition erreichen.

Bei vorteilhaften Weiterbildungen dieser Klasse von Ausführungsformen umfasst die Temperiereinrichtung einen Heizwiderstand und/oder ein Peltier-Element und/oder eine Einrichtung zur Warmluftzufuhr und/oder eine Einrichtung zur Zuführung von Infrarotstrahlung und/oder Mikrowellenstrahlung. Alternativ oder ergänzend kann bei Weiterbildungen dieser Klasse von Ausführungsformen die Temperiereinrichtung eine Einrichtung zur Druckluftexpansion und/oder eine Einrichtung zur Kaltluftzufuhr aufweisen. Je nach Temperaturbereich und Messprobentyp kann eine speziell angepasste, individuell für die jeweilige Probe optimale Heiz- oder Kühlmethode gewählt werden.

Bevorzugte Weiterbildungen können sich auch dadurch auszeichnen, dass die eine Parkaufnahme mindestens eine Temperieröffnung für einen Zugang der Temperiereinrichtung zur NMR-Messprobe in dem Transportbehälter umfasst. Um die Temperierung der Probe in der Parkstellung der Parkaufnahme möglichst unmittelbar und effizient durchführen zu können, erhält die Temperiereinrichtung durch die Temperieröffnung einen direkten Zugang durch die Wand der Parkaufnahme hindurch zum Transportbehälter mit der Probe.

Varianten dieser bevorzugten Weiterbildungen sind dadurch gekennzeichnet, dass das Wechselsystem mindestens eine verschwenkbare Heiz- oder Kühlbacke zur Temperierung des Transportbehälters mit NMR-Messprobe aufweist, wobei die verschwenkbare Heiz- oder Kühlbacke in einer Temperierposition der Parkaufnahme durch die Temperieröffnung greift.

Eine technisch besonders einfach zu realisierende Möglichkeit der Probentemperierung in der Parkaufnahme besteht darin, verschwenkbare Temperiermittel in Form von Heiz- oder Kühlbacken vorzusehen, welche bei Bedarf direkt auf den Transportbehälter einwirken können.

Bei weiteren Weiterbildungen weist -vorzugsweise jede Parkaufnahme eine eigene- elektronische Regeleinrichtung zur Regelung der Temperatur der NMR-Messprobe im zwischengespeicherten Transportbehälter auf. Damit können die NMR-Messproben automatisch auf unterschiedlichen Temperaturen gehalten werden und der Temperaturverlauf in jeder einzelnen Messprobe kann individuell verlaufen.

Besonders vorteilhafte Varianten dieser Weiterbildungen sind dadurch gekennzeichnet, dass die Regeleinrichtung so gestaltet ist, dass sie die NMR-Messprobe im zwischengespeicherten Transportbehälter entlang eines vorgegebenen zeitlichen Temperaturprofils temperieren kann.

Diese Varianten lassen sich schließlich noch dadurch weiter verbessern, dass das vorgegebene zeitliche Temperaturprofil so definiert ist, dass eine gewünschte Temperatur der NMR-Messprobe möglichst schnell erreicht wird, ohne dass dabei eine vorbestimmte Maximaltemperatur überschritten wird. Dadurch wird eine eventuelle Zerstörung der Messsubstanz verhindert.

Ist die Zieltemperatur nahe oder gleich der Maximaltemperatur, so muss die Parkaufnahme zwingend so nah als möglich an der Transportvorrichtung herangebracht werden, um die Transportzeit zu minimieren, während der sich die Temperatur der NMR-Messprobe aufgrund von Einflüssen der Umgebung verändert.

Des Weiteren sind auch Ausführungsformen des erfindungsgemäßen NMR-Spektrometers von großem Vorteil, die sich dadurch auszeichnen, dass das NMR-Spektrometer derart ausgestaltet, dass um mindestens eine Parkaufnahme ein Luftstrom geführt ist, der die NMR-Messprobe umströmt und die Feuchtigkeit, welche durch Kondensation aus der Luft sich an der NMR-Messprobe niederschlägt, fernhält oder entfernt. Ein wesentlicher Vorteil einer solchen Anordnung besteht darin, dass die Messprobe keine Feuchtigkeit in das NMR-Messsystem einbringt, was zu einer Verschmutzung und zu Schäden führen könnte. Derartige Feuchtigkeit kann zudem grundsätzlich die NMR-Messung stören.

Mit besonderem Vorteil lässt die Erfindung bei NMR-Spektrometern einsetzen, welche für Flüssigkeitsmessungen ausgelegt sind und bei denen die NMR-Messprobe flüssige Substanz enthält. Zum Transport der flüssigen Probe im Transportbehälter sind dann die Achsen von Transportvorrichtung und Transportkanal im Wesentlichen parallel zur Schwerkraft ausgerichtet. Während die in Referenz [1] gezeigte Anordnung ausschließlich für Festkörper-NMR geeignet ist, soll mit der vorliegenden Erfindung auch ein Spektrometer zur Vermessung von flüssigen NMR-Proben ausgestattet werden können. Beim Transport einer flüssigen Messprobe ist es hochgradig wünschenswert, dass die Flüssigkeit nicht aus dem Probenröhrchen auslaufen kann und dabei vielleicht ausgegossen wird. Daher ist das erfindungsgemäße Spektrometer geometrisch so ausgestaltet, dass die Achsen von Transportvorrichtung und Transportkanal in jeder Betriebsposition parallel zur Richtung der Schwerkraft ausgerichtet sind. Winkelabweichungen von bis zu ±5° sind dabei noch tolerabel. Bedingt durch diesen aufrechten Transport sind übrigens die in Referenz [1] genannten beheizbaren Zuführungsleitungen hier nicht mehr umsetzbar. Umgekehrt ist bei der Vorrichtung nach Referenz [1] explizit ein Transport der Probengefäße auch streckenweise in liegender Position vorgesehen, was die Verwendung von flüssigen NMR-Proben in dafür üblichen Transportbehältern ausschließt.

Die Transportvorrichtung sowie das Wechselsystem zur Aufnahme und Durchführung des Transportbehälters weisen also bei einem solchen zur Messung von flüssigen Proben modifizierten NMR-Spektrometer Hohlräume auf, deren Höhe größer als die maximale Länge des Transportbehälters ist, und die so ausgestaltet und geometrisch derart angeordnet sind, dass sie in Verlängerung der Zylinderachse des Transportkanals und/oder parallel dazu verlaufen, sodass der Transportbehälter mit der NMR-Messprobe stets in aufrechter Lage, also mit seiner Achse parallel zur Zylinderachse des Transportkanals, durch diese Hohlräume transportierbar ist.

Aus praktischen Gründen werden beim erfindungsgemäßen NMR-Spektrometer in der Regel der Transportkanal, die mindestens eine Parkaufnahme und gegebenenfalls die Durchgangsröhre jeweils zylinderförmig ausgeführt sein. Da ja auch die Transportbehälter üblicherweise eine zylindrische Form aufweisen, ist es am einfachsten, die Hohlräume von Transportkanal, Parkaufnahmen sowie der Durchgangsröhre ebenfalls zylindrisch zu gestalten.

In den Rahmen der vorliegenden Erfindung fällt auch ein Verfahren zum Betrieb eines erfindungsgemäßen NMR-Spektrometers der oben beschriebenen Art, mit folgenden Schritten:
(a) Zuführung eines von außen ankommenden ersten Transportbehälters mit einer ersten NMR-Messprobe durch den Transportkanal in das Magnetzentrum in der Bohrung des NMR-Magnetsystems sowie Einführen mindestens eines weiteren von außen ankommenden Transportbehälters mit einer weiteren NMR-Messprobe in eine Parkaufnahme des Wechselsystems und zeitweiliges Zwischenspeichern während einer Parkdauer tₚ;
(b) Durchführen einer NMR-Messung an der ersten NMR-Messprobe;
(c) pneumatischer Rücktransport des ersten Transportbehälters mit der ersten NMR-Messprobe aus dem Magnetzentrum nach außerhalb des NMR-Magnetsystems;
(d) pneumatischer Weitertransport eines der zwischengespeicherten weiteren Transportbehälter mit einer weiteren NMR-Messprobe aus der Parkaufnahme des Wechselsystems in das Magnetzentrum.

Ein erheblicher Vorteil dieses Verfahrens ist ein schneller Wechsel der jeweils zu vermessenden Probe.

Vorteilhafte Weiterbildungen dieses Verfahrens sind dadurch gekennzeichnet, dass bis zu zwölf weitere von außen ankommende Transportbehälter, die jeweils eine weitere NMR-Messprobe enthalten, jeweils in eine der Parkaufnahmen des Wechselsystems pneumatisch eingeführt, während einer Parkdauer zwischen tₚ und 12·tₚ zeitweilig zwischengespeichert, einer NMR-Messung im Magnetzentrum zugeführt und anschließend pneumatisch aus dem Magnetzentrum nach außerhalb des NMR-Magnetsystems zurücktransportiert werden.

Alternativ oder ergänzend können auch Weiterbildungen des erfindungsgemäßen Verfahrens zum Einsatz gelangen, bei welchen die weiteren NMR-Messproben während der Zwischenspeicherung ihres jeweiligen Transportbehälters in einer der Parkaufnahmen des Wechselsystems, vorzugsweise elektronisch geregelt, temperiert -insbesondere beheizt und/oder gekühlt- werden.

Besonders bevorzugt sind Varianten dieser Weiterbildungen, welche sich dadurch auszeichnen, dass die NMR-Messproben in einem der zwischengespeicherten Transportbehälter entlang eines vorgegebenen zeitlichen Temperaturprofils temperiert werden.

Diese Verfahrensvarianten können noch dadurch verbessert werden, dass die NMR-Messproben in einem der zwischengespeicherten Transportbehälter derart temperiert werden, dass eine gewünschte Temperatur der jeweiligen NMR-Messprobe möglichst schnell erreicht wird, ohne dass dabei eine vorbestimmte Maximaltemperatur überschritten wird.

Eine besonders vorteilhafte Weiterbildung des oben beschriebenen erfindungsgemäßen Verfahrens schließlich ist dadurch gekennzeichnet, dass die NMR-Messprobe während der Zwischenspeicherung ihres Transportbehälters in einer der Parkaufnahmen des Wechselsystems von trockener Luft umströmt wird.

Weitere Vorteile der Erfindung ergeben sich aus der Beschreibung und der Figuren. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert.

Es zeigen:
- Fig. 1: eine schematisierte, teil-transparente Seitenansicht auf eine Ausführungsform des erfindungsgemäßen NMR-Spektrometers;
- Fig. 2a: eine schematische vertikale Schnittansicht von der Seite auf ein Wechselsystem mit einer Vielzahl von (hier zwölf) Parkaufnahmen in einer Betriebsstellung zum Auswurf einer gerade vermessenen Probe aus dem Magnetzentrum des Magnetsystems;
- Fig. 2b: wie Fig. 2a, aber in einer Betriebsstellung zum Überführen einer neu zu vermessenden Probe aus dem Wechselsystem in das Magnetzentrum des Magnetsystems sowie Beladung der gerade frei gewordenen Parkaufnahme dieser neu zu vermessenden Probe mit einer weiteren Probe von außerhalb des NMR-Spektrometers; und
- Fig. 3: eine vergrößerte schematische Detailansicht einer geregelt temperierbaren Parkaufnahme sowie einer Durchgangsröhre für den schnellen Auswurf der letzten vermessenen Probe aus dem Magnetsystem nach außerhalb des NMR-Spektrometers.

Generell befasst sich die vorliegende Erfindung mit einem modifizierten **NMR-Spektrometer 1.** Die Vorteile der Erfindung können aber auch bei einem Spektrometer mit anderer physikalischer Messtechnik genutzt werden, wobei dann womöglich entsprechende geeignete Modifikationen vorgenommen werden müssen.

Die Erfindung bildet ein gattungsgemäßes NMR-Spektrometer 1 weiter mit einem **NMR-Magnetsystem 2,** das eine **Bohrung 3** durch das **Magnetzentrum 4** zum Einführen von **NMR-Messproben 5** aufweist, sowie mit einer Transportvorrichtung zur pneumatischen Beförderung der NMR-Messproben 5 in einem **Transportbehälter 7** durch einen **Transportkanal 8,** Zuführung zur NMR-Messung in das Magnetzentrum 4 und Rücktransport aus dem NMR-Magnetsystem 2, wobei die Transportvorrichtung eine an einem offenen Ende der Bohrung 3 angeordnete **mechanische Schnittstelle 9** zu externen Geräten umfasst, an der ein **Wechselsystem 10** montiert ist, welches mindestens eine **Parkaufnahme 11** zum Zwischenspeichern eines Transportbehälters 7 aufweist, wobei die Parkaufnahme 11 in einer Transportposition zur Beladung mit einem Transportbehälter 7 in den Transportkanal 8 eingebracht, zum Zwischenspeichern des Transportbehälters 7 aus dem Transportkanal 8 entfernt und zum Weitertransport des Transportbehälters 7 wieder in den Transportkanal 8 eingebracht werden kann.

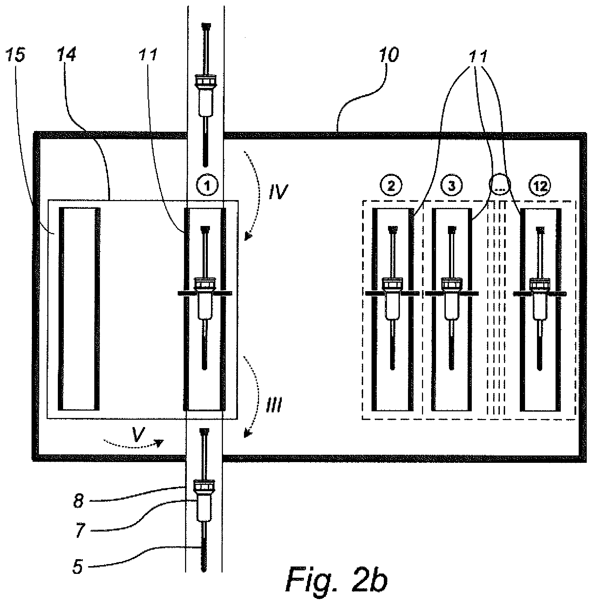

Die vorliegende Erfindung ist demgegenüber dadurch charakterisiert, dass die Parkaufnahme 11 in der Transportposition einen Teil des Transportkanals 8 bildet, was insbesondere in Fig. 2b schematisch dargestellt ist.

Neu bei dem erfindungsgemäßen Wechselsystem 10 mit einem oder mehreren Zwischenspeichern in Form der Parkaufnahmen 11, in denen NMR-Messproben 5 mit ihrem jeweiligen Transportbehälter 7 parkiert werden können, ist vor allem, dass es *direkt* an der mechanischen Schnittstelle 9 zu externen Geräten des NMR-Spektrometers 1 montiert ist. Dabei ist die Transportvorrichtung unmittelbar auf dem offenen Ende der Magnetbohrung 3 angeordnet. Die mechanische Schnittstelle 9 sowie das Wechselsystem 10 sind mit einem geringen Abstand über dem offenen Ende der Magnetbohrung 3 angekoppelt. Der Abstand zwischen dem Wechselsystem 10 und der Magnetbohrung 3 beträgt etwa 50mm bis 200mm, vorzugsweise ungefähr 80mm. Aufgrund dieser kompakten Anordnung und der unmittelbaren Nähe des Wechselsystems 10 zum Magnetzentrum 4 ist ein Wechsel einer Messprobe sehr viel schneller möglich als bisher.

Die Parkaufnahmen 11 im Wechselsystem 10 dienen zum zeitweiligen Zwischenspeichern eines von außen ankommenden Transportbehälters 7 mit einer NMR-Messprobe 5 während einer Parkdauer tₚ, wobei während dieser Parkdauer tₚ eine andere NMR-Messprobe 5 zur Messung im Magnetzentrum 4 angeordnet ist. Jede Parkaufnahme 11 ist innerhalb des Wechselsystems 10 derart verschiebbar, dass sie zur Beladung mit einem von außen ankommenden weiteren Transportbehälter 7 in den Transportkanal 8 eingebracht, zum Zwischenspeichern des Transportbehälters 7 während der Parkdauer tₚ aus dem Transportkanal 8 entfernt und zum Weitertransport der NMR-Messprobe 5 des zwischengespeicherten Transportbehälters 7 zur Messung im Magnetzentrum 4 wieder in den Transportkanal 8 eingebracht werden kann. In der Transportposition bildet also die jeweilige Parkaufnahme 11 einen Teil des Transportkanals 8.

Vorzugsweise ist beim erfindungsgemäßen NMR-Spektrometer 1 um mindestens eine der Parkaufnahmen 11, am bestem um alle, ein Luftstrom geführt, der die NMR-Messprobe 5 umströmt und die Feuchtigkeit, welche durch Kondensation aus der Luft sich an der NMR-Messprobe 5 niederschlägt, fernhält oder entfernt. Diese vorteilhafte Modifikation ist allerdings aus Gründen der Übersichtlichkeit nicht eigens in der Zeichnung dargestellt.

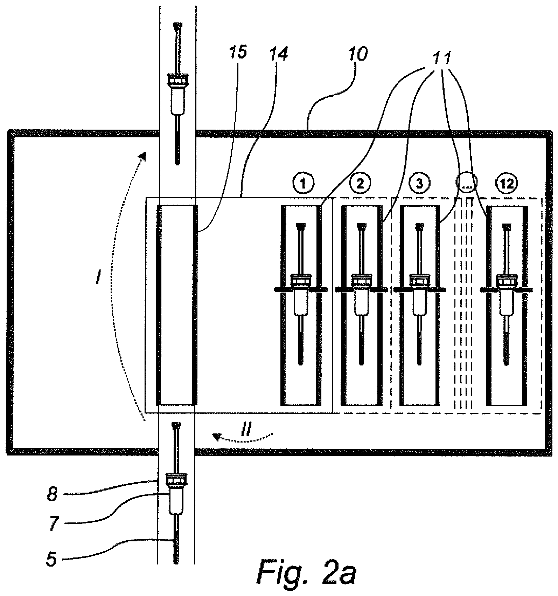

Das Wechselsystem 10 kann eine Vielzahl von Parkaufnahmen 11 enthalten. Bei dem in den Figuren 2a und 2b schematisch dargestellten Ausführungsbeispiel sind es genau zwölf Parkaufnahmen 11.

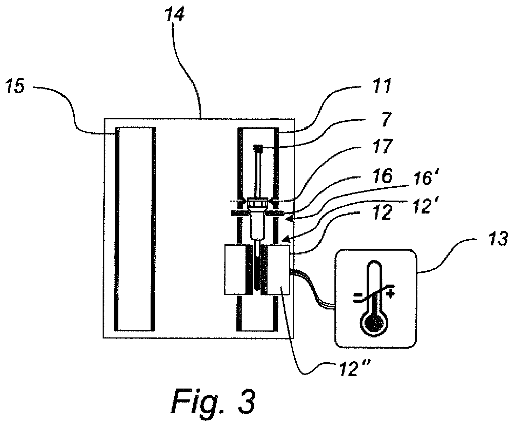

Des Weiteren enthält die in Fig. 3 gezeigten Parkaufnahme 11 eine **Temperiereinrichtung 12,** mittels der ein in der Parkaufnahme 11 zwischengespeicherter Transportbehälter 7, insbesondere die NMR-Messprobe 5 im Transportbehälter 7, beheizbar und/oder kühlbar ist.

Diese Temperiereinrichtung 12 kann im Detail in unterschiedlichen Weisen ausgestaltet sein. So kann sie etwa einen Heizwiderstand und/oder ein Peltier-Element und/oder eine Einrichtung zur Warmluftzufuhr und/oder eine Einrichtung zur Zuführung von Infrarotstrahlung und/oder Mikrowellenstrahlung umfassen und/oder eine Einrichtung zur Druckluftexpansion und/oder eine Einrichtung zur Kaltluftzufuhr aufweisen.

Die Parkaufnahmen 11 haben Temperieröffnungen 12' für einen Zugang der Temperiereinrichtung 12 zur NMR-Messprobe 5 in dem Transportbehälter 7. Bei dem in Fig. 3 gezeigten Ausführungsbeispiel weist die Parkaufnahme 11 im Wechselsystem 10 zwei verschwenkbare Heiz- oder Kühlbacken 12" zur Temperierung der NMR-Messprobe 5 im Transportbehälter 7 auf, welche in einer Temperierposition der Parkaufnahme 11 durch die Temperieröffnung 12' greifen.

Derartige können natürlich auch bei Ausführungsformen mit mehreren Parkaufnahmen 11 verwirklicht sein, vorzugsweise dann bei jeder der Parkaufnahmen 11. In den Figuren 2a und 2b sind sie aber der Übersichtlichkeit wegen nicht eigens dargestellt. Denkbar sind auch -ebenfalls in der Zeichnung nicht dargestellte-Ausführungsformen des erfindungsgemäßen Wechselsystems 10, bei welchen zwar eine Vielzahl von Parkaufnahmen 11 vorhanden ist, von denen jede eine oder mehrere Temperieröffnungen 12' aufweist, wobei aber nur eine einzige Anordnung von verschwenkbare Heiz- oder Kühlbacken 12" vorgesehen ist, die in einer besonderen Temperierposition auf die dort befindliche Parkaufnahme 11 einwirken können.

Das erfindungsgemäße NMR-Spektrometer 1 wird üblicherweise elektronisch gesteuert. Dies gilt natürlich auch für Untereinheiten, wie etwa das oben beschriebene Wechselsystem 10, dessen Parkaufnahmen 11 und die Temperiereinrichtung 12. Vorzugsweise wird jede Parkaufnahme 11 eine eigene elektronische **Regeleinrichtung 13** zur Regelung der Temperatur der NMR-Messprobe 5 im zwischengespeicherten Transportbehälter 7 aufweisen, wie im schematischen Ausführungsbeispiel von Fig. 3 bildlich dargestellt ist.

Die Regeleinrichtung 13 kann so gestaltet sein, dass sie die NMR-Messprobe 5 im zwischengespeicherten Transportbehälter 7 entlang eines vorgegebenen zeitlichen Temperaturprofils temperieren kann. Diese bevorzugte Modifikation ist jedoch in der Zeichnung wiederum nicht eigens dargestellt. Vorzugsweise wird das vorgegebene zeitliche Temperaturprofil so definiert, dass eine gewünschte Temperatur der NMR-Messprobe 5 möglichst schnell erreicht wird, ohne dass dabei eine vorbestimmte Maximaltemperatur überschritten wird.

Ein erfindungsgemäß gestaltetes Wechselsystem 10 kann -wie in den Figuren 2a, 2b und 3 angedeutet- einen beweglichen, insbesondere linear verschiebbaren oder drehbaren **Schlitten 14** aufweisen, welcher jeweils eine der Parkaufnahmen 11 sowie eine azimutal geschlossene, an ihren axialen Enden jeweils offene **Durchgangsröhre 15** trägt, die in der Transportposition einen Teil des Transportkanals 8 bildet. Wenn diese Durchgangsröhre 15 in die Transportposition eingebracht ist, kann eine im Magnetzentrum 4 bereits vermessene NMR-Messprobe 5 in ihrem Transportbehälter 7 zügig und ohne Zwischenaufenthalt durch das Wechselsystem 10 hindurch aus dem NMR-Magnetsystem 2 heraus nach außerhalb des NMR-Spektrometers 1 transportiert werden, um das Messzentrum für eine neue, noch zu vermessende Probe aus dem Wechselsystem 10 freizumachen.

Die in den Figuren 2a, 2b und 3 dargestellten Parkaufnahmen 11 weisen jeweils einen **Sperrmechanismus 16** auf, welcher den Transportbehälter 7 nach Einführung in die jeweilige Parkaufnahme 11 fixiert und in der Transportposition die Durchführung des Transportbehälters 7 aus der Parkaufnahme 11 heraus in das Magnetzentrum 4 freigeben kann.

Bei den in der Zeichnung dargestellten Ausführungsformen der Erfindung weisen die Parkaufnahmen 11 jeweils **Sperröffnungen 16'** zum Durchgriff des Sperrmechanismus 16 auf den Transportbehälter 7 in der Parkaufnahme 11 auf. Der Sperrmechanismus 16 ist hier Teil der jeweiligen Parkaufnahme 11 und umfasst jeweils ein System von Sperrstiften, die durch die Sperröffnungen 16' hindurch auf den Transportbehälter 7 in der Parkaufnahme 11 greifen können.

Die Parkaufnahmen 11 der Ausführungsformen in den Figuren 2a, 2b und 3 umfassen jeweils eine **Sensorvorrichtung 17,** mittels welcher erkannt werden kann, ob sich aktuell ein Transportbehälter 7 in der Parkaufnahme 11 befindet oder nicht.

Innerhalb des Transportkanals 8 ist -wie in Fig. 1 angedeutet- eine **Einrichtung 6a zum pneumatischen Weitertransport** eines von außen ankommenden Transportbehälters 7 in das Magnetzentrum 4 sowie eines aus dem Magnetzentrum 4 kommenden Transportbehälters 7 mit vermessener Probe zurück nach außerhalb des NMR-Magnetsystems 2 vorgesehen. Zudem kann auch eine **Sensoreinrichtung 6b** zur Erkennung eines Transportbehälters 7 in unmittelbarer Nähe des Magnetzentrums 4 angeordnet sein.

Wie in sämtlichen Figuren der Zeichnung dargestellt, sind die Achsen von Transportvorrichtung, Transportkanal 8 und sämtlichen Parkaufnahmen 11 im Wesentlichen parallel zur Schwerkraft ausgerichtet, so dass in Fällen, in denen die NMR-Messprobe 5 flüssige Substanz enthält, die Transportbehälter 7 mit der flüssigen Probe stets in aufrechter Position transportiert werden. Dadurch, wird die Flüssigkeit während des Transports nicht verschüttet. Die Transportvorrichtung sowie das Wechselsystem 10 zur Aufnahme und Durchführung der Transportbehälter 7 weisen also bei einem solchen zur Messung von flüssigen Proben modifizierten NMR-Spektrometer 1 Hohlräume auf, deren Höhe größer als die maximale Länge der Transportbehälter 7 ist, und die so ausgestaltet und geometrisch derart angeordnet sind, dass sie in Verlängerung der Zylinderachse des Transportkanals 8 und/oder parallel dazu verlaufen, sodass jeder Transportbehälter 7 mit einer NMR-Messprobe 5 stets in aufrechter Lage, also mit seiner Achse parallel zur Zylinderachse des Transportkanals 8, durch diese Hohlräume transportierbar ist.

Die Erfindung beinhaltet ein Proben-Wechselsystem, das direkt auf dem -an sich bekannten- BST sitzt. In diesem Wechselsystem 10 werden die NMR-Messproben 5 zwischengelagert und vortemperiert. Wenn eine vermessene Probe aus dem Magnetzentrum 4 durch das BST schnell nach oben transportiert werden soll, wird sie direkt durch die Durchgangsröhre 15 an den im Wechselsystem 10 zwischengelagerten ("geparkten") Proben in ihren Parkaufnahmen 11 vorbei transportiert. Sobald die vermessene Probe aus Magnetzentrum 4 die weiteren Proben passiert hat, wird die nächste NMR-Messprobe 5 in den Transportkanal 8 gebracht und unmittelbar danach nach unten in das Magnetzentrum 4 zur NMR-Messung befördert. Dadurch reduziert sich die Wartezeit des NMR-Systems auf lediglich diejenige Zeit, die erforderlich ist um eine Probe über die -nunmehräußerst kurze Strecke nach oben und eine andere Probe nach unten zu befördern. Zusätzlich kommt durch die Vortemperierung die zu vermessende NMR-Messprobe 5 gleich ziemlich exakt auf der gewünschten Zieltemperatur im Magnetzentrum 4 an, so dass die NMR-Messung sofort und ohne weitere Wartezeit unter thermisch optimalen Bedingungen durchgeführt werden kann.

Der heute bei der Firma Bruker übliche BST-Adapter (Funktion: Kombination von USC-Shuttle und (Glas)-Sample) und die heute bereits außerhalb des NMR-Spektrometers oftmals vorhandene Vorheizstation (siehe Referenz [1]) werden durch die Erfindung nunmehr direkt über dem BST vereint und mit einem temperierbaren Proben-Wechselsystem ergänzt:
Die Funktion dieses Schnellwechselsystems und insbesondere der Ablauf der Belade- und Entlade-Vorgänge sind durch die Pfeile I bis V in den Figuren 2a und 2b angedeutet. In der Ausgangssituation ist eine NMR-Messprobe 5 im Magnetzentrum 4 des NMR-Magnetsystems 2 für eine NMR-Messung positioniert und wird dort vermessen.

Der weitere Ablauf ist folgender:
I. Sofort nach Abschluss der NMR-Messung wird die vermessene NMR-Messprobe 5 in ihrem Transportbehälter 7 aus dem Magnetzentrum 4 herausbefördert in das Wechselsystem 10 (siehe Fig. 2a).
II. Nach der Passage der vermessenen Probe direkt durch die Durchgangsröhre 15 an den im Wechselsystem 10 geparkten Proben vorbei wird eine der geparkten Proben (in Fig. 2a die Nummer 1) mit ihrer Parkaufnahme 11 zum Transportkanal 8 auf der Achse des NMR-Systems befördert.
III. Auf dem Schlitten 14 wird die Durchgangsröhre 15 nach dem Durchgang der vermessenen Probe durch das Wechselsystem 10 aus ihrer Transportposition im Transportkanal 8 herausbewegt, die nächste zu vermessende zwischengeparkte Probe (in Fig. 2b wiederum die Nummer 1) wird mit ihrer Parkaufnahme 11 auf die Achse des Transportkanals 8 bewegt, Sperrmechanismus 16 gibt die Probe (Nr. 1) frei und diese wird zur NMR-Messung aus ihrer Parkaufnahme 11 heraus in das Magnetzentrum 4 abgesenkt.
IV. Sobald die NMR-Messprobe 5 (Nr. 1 in Fig. 2b) in ihrem Transportbehälter 7 ihre Parkaufnahme 11 verlassen hat, wird letztere mit einer weiteren, von außerhalb des NMR-Spektrometers ankommenden Probe beladen.
V. Die Parkaufnahme 11 mit der neu hinzugekommenen Probe wird mittels des Schlittens 14 aus dem Transportkanal 8 heraus auf eine Parkstellung im Wechselsystem 10 befördert und dort vortemperiert. Gleichzeitig wird die Durchgangsröhre 15 -zur Vorbereitung eines schnellen Auswurfs der aktuell im Magnetzentrum 4 befindlichen NMR-Messprobe 5 nach Abschluss von deren Vermessung- mit derselben Schlittenbewegung auf die Achse des Transportkanals 8 im Wechselsystem 10 zurückgeschoben.

Das Resultat aus dieser Vorgehensweise ist insbesondere, dass die Totzeit, in der keine Messprobe im NMR-Magneten vermessen werden kann, nur noch ca. 10 Sekunden beträgt. Demgegenüber beträgt diese minimale Wartezeit bei heutigen NMR-Spektrometer nach dem Stand der Technik ca. 45 Sekunden.

### Bezugszeichenliste:

- 1: NMR- Spektrometer
- 2: NMR-Magnetsystem
- 3: Bohrung
- 4: Magnetzentrum
- 5: NMR-Messprobe(n)
- 6a: Einrichtung zum pneumatischen Weitertransport
- 6b: Sensoreinrichtung
- 7: Transportbehälter
- 8: Transportkanal
- 9: mechanische Schnittstelle
- 10: Wechselsystem
- 11: Parkaufnahme(n)
- 12: Temperiereinrichtung
- 12': Temperieröffnung
- 12": Heiz- oder Kühlbacken
- 13: Regeleinrichtung
- 14: Schlitten
- 15: Durchgangsröhre
- 16: Sperrmechanismus
- 16': Sperröffnung(en)
- 17: Sensorvorrichtung
- I-V: Messzyklus

### Referenzliste:

Für die Beurteilung der Patentfähigkeit in Betracht gezogene Publikationen:
[1] DE 10 2004 029 633 B4
[2] Firmenbroschüre Z31123"Bruker Sample Transport. BST Installation and Technical Manual Version 002" der Bruker BioSpin AG vom 21. November 2008
[3] EP 2 199 816 B1
[4] DE 37 29 819 C2
[5] DE 10 2013 212 312 B4

## Patentansprüche

1. NMR-Spektrometer (1) mit einem NMR-Magnetsystem (2), das eine Bohrung (3) durch das Magnetzentrum (4) zum Einführen einer NMR-Messprobe (5) in einem Transportbehälter (7) aufweist, sowie mit einer Transportvorrichtung zur pneumatischen Beförderung der NMR-Messprobe (5) durch einen Transportkanal (8) in das NMR-Magnetsystem (2) hinein und aus dem NMR-Magnetsystem (2) heraus, wobei die Transportvorrichtung eine mechanische Schnittstelle (9) umfasst, an der ein Wechselsystem (10) montiert ist, welches mindestens eine Parkaufnahme (11) zum Zwischenspeichern eines Transportbehälters (7) aufweist, wobei die Parkaufnahme (11) in einer Transportposition zur Beladung mit einem Transportbehälter (7) in den Transportkanal (8) eingebracht, zum Zwischenspeichern des Transportbehälters (7) aus dem Transportkanal (8) entfernt und zum Weitertransport des Transportbehälters (7) wieder in den Transportkanal (8) eingebracht werden kann,
**dadurch gekennzeichnet,**
**dass** die Parkaufnahme (11) in der Transportposition einen Teil des Transportkanals (8) bildet.

2. NMR-Spektrometer nach Anspruch 1, **dadurch gekennzeichnet, dass** das Wechselsystem (10) einen Sperrmechanismus (16) aufweist, welcher die Durchführung des Transportbehälters (7) in das NMR-Magnetsystem (2) entweder absperren oder freigeben kann.

3. NMR-Spektrometer nach Anspruch 2, **dadurch gekennzeichnet, dass** die mindestens eine Parkaufnahme (11) Sperröffnungen (16') zum Durchgriff des Sperrmechanismus (16) auf den Transportbehälter (7) der Parkaufnahme (11) aufweist.

4. NMR-Spektrometer nach Anspruch 3, **dadurch gekennzeichnet, dass** der Sperrmechanismus (16) Teil der mindestens einen Parkaufnahme (11) ist und insbesondere ein System von Sperrstiften umfasst, die durch die Sperröffnungen (16') hindurch auf den Transportbehälter (7) in der Parkaufnahme (11) greifen können.

5. NMR-Spektrometer nach einem der vorhergehenden Ansprüche, **dadurch gekennzeichnet, dass** das Wechselsystem (10) zum Transport eines Transportbehälters (7) aus dem NMR-Magnetsystem (2) heraus und durch das Wechselsystem (10) hindurch eine azimutal geschlossene, an ihren axialen Enden jeweils offene Durchgangsröhre (15) umfasst, die in die Transportposition eingebracht werden kann.

6. NMR-Spektrometer nach einem der vorhergehenden Ansprüche, **dadurch gekennzeichnet, dass** das Wechselsystem (10) mehrere Parkaufnahmen (11), insbesondere 12 Parkaufnahmen (11), umfasst.

7. NMR-Spektrometer nach einem der vorhergehenden Ansprüche, **dadurch gekennzeichnet, dass** das Wechselsystem (10) eine Temperiereinrichtung (12) aufweist, mittels der ein in der mindestens einen Parkaufnahme (11) zwischengespeicherter Transportbehälter (7) mit NMR-Messprobe (5) beheizbar und/oder kühlbar ist.

8. NMR-Spektrometer nach Anspruch 7, **dadurch gekennzeichnet, dass** die Temperiereinrichtung (12) einen Heizwiderstand und/oder ein Peltier-Element und/oder eine Einrichtung zur Warmluftzufuhr und/oder eine Einrichtung zur Zuführung von Infrarotstrahlung und/oder Mikrowellenstrahlung und/oder eine Einrichtung zur Druckluftexpansion und/oder eine Einrichtung zur Kaltluftzufuhr umfasst.

9. NMR-Spektrometer nach Anspruch 7 oder 8, **dadurch gekennzeichnet, dass** die mindestens eine Parkaufnahme (11) mindestens eine Temperieröffnung (12') für einen Zugang der Temperiereinrichtung (12) zur NMR-Messprobe (5) in dem Transportbehälter (7) umfasst.

10. NMR-Spektrometer nach Anspruch 9, **dadurch gekennzeichnet, dass** das Wechselsystem (10) mindestens eine verschwenkbare Heiz- oder Kühlbacke (12") zur Temperierung des Transportbehälters (7) mit NMR-Messprobe (5) aufweist, wobei die verschwenkbare Heiz- oder Kühlbacke in einer Temperierposition der Parkaufnahme (11) durch die Temperieröffnung (12') greift.

11. NMR-Spektrometer nach einem der Ansprüche 7 bis 10, **dadurch gekennzeichnet, dass** eine elektronische Regeleinrichtung (13) zur Regelung der Temperatur der NMR-Messprobe (5) im zwischengespeicherten Transportbehälter (7) vorgesehen ist, vorzugsweise für jede Parkaufnahme (11) eine eigene elektronische Regeleinrichtung (13).

12. NMR-Spektrometer nach Anspruch 11, **dadurch gekennzeichnet, dass** die Regeleinrichtung (13) so gestaltet ist, dass sie die NMR-Messprobe (5) im zwischengespeicherten Transportbehälter (7) entlang eines vorgegebenen zeitlichen Temperaturprofils temperieren kann, wobei das vorgegebene zeitliche Temperaturprofil so definiert ist, dass eine gewünschte Temperatur der NMR-Messprobe (5) möglichst schnell erreicht wird, ohne dass dabei eine vorbestimmte Maximaltemperatur überschritten wird.

13. NMR-Spektrometer nach einem der vorhergehenden Ansprüche, **dadurch gekennzeichnet, dass** die NMR-Messprobe (5) flüssige Substanz enthält, und dass zum Transport der flüssigen Probe im Transportbehälter (7) die Achse des Transportkanals (8) im Wesentlichen parallel zur Schwerkraft ausgerichtet ist.

14. NMR-Spektrometer nach einem der vorhergehenden Ansprüche, **dadurch gekennzeichnet, dass** der Transportkanal (8), die mindestens eine Parkaufnahme (11) und gegebenenfalls die Durchgangsröhre (15) jeweils zylinderförmig sind.

15. Verfahren zum Betrieb eines NMR-Spektrometers (1) nach einem der Ansprüche 1 bis 14, **gekennzeichnet durch** folgende Schritte:
(a) Zuführung eines von außen ankommenden ersten Transportbehälters (7) mit einer ersten NMR-Messprobe (5) durch den Transportkanal (8) in das Magnetzentrum (4) sowie Einführen mindestens eines weiteren von außen ankommenden Transportbehälters (7) mit einer weiteren NMR-Messprobe (5) in eine Parkaufnahme (11) des Wechselsystems (10) und zeitweiliges Zwischenspeichern während einer Parkdauer tp;
(b) Durchführen einer NMR-Messung an der ersten NMR-Messprobe (5);
(c) pneumatischer Rücktransport des ersten Transportbehälters (7) mit der ersten NMR-Messprobe (5) aus dem Magnetzentrum (4) nach außerhalb des NMR-Magnetsystems (2);
(d) pneumatischer Weitertransport des zwischengespeicherten weiteren Transportbehälters (7) aus der Parkaufnahme (11) des Wechselsystems (10) in das Magnetzentrum (4).

## Claims

1. NMR spectrometer (1) with an NMR magnet system (2), which has a bore (3) through the magnet center (4) for inserting an NMR measuring sample (5) in a transport container (7), and with a transport device for the pneumatic transport of the NMR measuring sample (5) through a transport channel (8) into the NMR magnet system (2) and out of the NMR magnet system (2), wherein the transport device comprises a mechanical interface (9), on which a changing system (10) is mounted which comprises at least one parking receptacle (11) for temporarily storing a transport container (7), wherein, in a transport position, the parking receptacle (11) can be inserted into the transport channel (8) in order to be loaded with a transport container (7), removed from the transport channel (8) for temporarily storing the transport container (7), and reinserted into the transport channel (8) for further transport of the transport container (7),
**characterized in that,**
in the transport position, the parking receptacle (11) forms a part of the transport channel (8).

2. NMR spectrometer according to claim 1, **characterized in that** the changing system (10) comprises a lock mechanism (16) which can either block or release the passage of the transport container (7) into the NMR magnet system (2).

3. NMR spectrometer according to claim 2, **characterized in that** the at least one parking receptacle (11) has lock openings (16'), through which the lock mechanism (16) can engage with the transport container (7) of the parking receptacle (11).

4. NMR spectrometer according to claim 3, **characterized in that** the lock mechanism (16) is part of the at least one parking receptacle (11) and particularly comprises a system of locking pins which can engage through the lock openings (16') with the transport container (7) in the parking receptacle (11).

5. NMR spectrometer according to one of the previous claims, **characterized in that** the changing system (10) for transporting a transport container (7) out of the NMR magnet system (2) and through the changing system (10) comprises an azimuthally closed through-tube (15) which is open at its axial ends and which can be inserted into the transport position.

6. NMR spectrometer according to one of the previous claims, **characterized in that** the changing system (10) comprises a plurality of parking receptacles (11), particularly 12 park receptacles (11).

7. NMR spectrometer according to one of the previous claims, **characterized in that** the changing system (10) comprises a tempering device (12), by means of which a transport container (7) with an NMR measuring sample (5), temporarily stored in the parking receptacle (11), can be heated and/or cooled.

8. NMR spectrometer according to claim 7, **characterized in that** the tempering device (12) comprises a heating resistor and/or a Peltier element and/or a means for hot air supply and/or a means for introducing infrared radiation and/or microwave radiation and/or a device for compressed air expansion and/or a device for cold air supply.

9. NMR spectrometer according to claim 7 or 8, **characterized in that** the at least one parking receptacle (11) comprises at least one tempering opening (12') for access of the tempering device (12) to the NMR measuring sample (5) in the transport container (7).

10. NMR spectrometer according to claim 9, **characterized in that** the changing system (10) has at least one pivotable heating or cooling jaw (12") for tempering the transport container (7) with an NMR measuring sample (5), wherein, in a tempering position of the parking receptacle (11), the pivotable heating or cooling jaw reaches through the tempering opening (12').

11. NMR spectrometer according to one of the claims 7 to 10, **characterized in that** an electronic control device (13) for controlling the temperature of the NMR measuring sample (5) in the temporarily stored transport container (7) is provided, each parking space (11) preferably having its own electronic control device (13).

12. NMR spectrometer according to claim 11, **characterized in that** the control device (13) is designed such that it can temper the NMR measuring sample (5) in the temporarily stored transport container (7) along a predetermined temporal temperature profile, wherein the predetermined temporal temperature profile is defined such that a desired temperature of the NMR measuring sample (5) is reached as quickly as possible without exceeding a predetermined maximum temperature.

13. NMR spectrometer according to one of the previous claims, **characterized in that** the NMR measuring sample (5) contains a liquid substance, and that, for transporting the liquid sample in the transport container (7), the axis of the transport channel (8) is aligned essentially parallel to gravity.

14. NMR spectrometer according to one of the previous claims, **characterized in that** the transport channel (8), the at least one parking receptacle (11), and optionally the through-tube (15) are each cylindrical.

15. Method for operating an NMR spectrometer (1) according to one of the claims 1 to 14, **characterized by** the following steps:
(a) Feeding a first transport container (7) arriving from the outside
with a first NMR measuring sample (5) through the transport channel (8) into the magnet center(4) and inserting at least one further transport container (7) arriving from the outside with a further NMR Measuring sample (5) into a parking receptacle (11) of the changing system (10) and temporarily storing it during a parking duration tp;
(b) performing an NMR measurement on the first NMR measuring sample (5);
(c) pneumatic return transport of the first transport container (7) with the first NMR measuring sample (5) from the magnet center (4) to the outside of the NMR magnet system (2);
(d) pneumatic further transport of the temporarily stored further transport container (7) from the parking receptacle (11) of the changing system (10) into the magnet center (4).

## Revendications

1. Spectromètre RMN (1) comprenant un système magnétique RMN (2) qui comporte un alésage (3), ménagé à travers le centre magnétique (4) et destiné à introduire un échantillon de mesure RMN (5) dans un contenant de transport (7), et un dispositif de transport destiné au transport pneumatique de l'échantillon de mesure RMN (5) à travers un conduit de transport (8) pour l'introduire dans le système magnétique RMN (2) et le faire sortir du système magnétique RMN (2), le dispositif de transport comprenant une interface mécanique (9) sur laquelle est monté un système d'échange (10) qui comporte au moins un logement de réception (11) destiné à recevoir temporairement un contenant de transport (7), le logement de réception (11) pouvant être introduit dans le conduit de transport (8) dans une position de transport en vue du chargement avec un contenant de transport (7), retiré du conduit de transport (8) en vue du logement temporaire du contenant de transport (7) et de nouveau introduit dans le conduit de transport (8) en vue d'un transport ultérieur du contenant de transport (7),
**caractérisé en ce que**
le logement de réception (11) forme une partie du conduit de transport (8) dans la position de transport.

2. Spectromètre RMN selon la revendication 1, **caractérisé en ce que** le système d'échange (10) comporte un mécanisme de blocage (16) qui peut soit bloquer soit libérer la mise en place du contenant de transport (7) dans le système magnétique RMN (2).

3. Spectromètre RMN selon la revendication 2, **caractérisé en ce que** l'au moins un logement de réception (11) comporte des ouvertures de blocage (16') permettant au mécanisme de blocage (16) d'accéder au contenant de transport (7) du logement de réception (11).

4. Spectromètre RMN selon la revendication 3, **caractérisé en ce que** le mécanisme de blocage (16) fait partie de l'au moins un logement de réception (11) et comprend notamment un système de goupilles de blocage qui peuvent s'engager à travers les ouvertures de blocage (16') pour venir en prise sur le contenant de transport (7) dans le logement de réception (11).

5. Spectromètre RMN selon l'une des revendications précédentes, **caractérisé en ce que**, pour transporter un contenant de transport (7) en dehors du système magnétique RMN (2) et à travers le système d'échange (10), le système d'échange (10) comprend un tube traversant (15), qui est fermé de manière azimutale, qui est ouvert à chacune de ses extrémités axiales et qui peut être amenée dans la position de transport.

6. Spectromètre RMN selon l'une des revendications précédentes, **caractérisé en ce que** le système d'échange (10) comprend une pluralité de logements de réception (11), notamment 12 logements de réception (11).

7. Spectromètre RMN selon l'une des revendications précédentes, **caractérisé en ce que** le système d'échange (10) comporte un moyen de régulation de température (12) permettant de chauffer et/ou de refroidir le contenant de transport (7), pourvu de l'échantillon de mesure RMN (5), logé temporairement dans l'au moins un logement de réception (11).

8. Spectromètre RMN selon la revendication 7, **caractérisé en ce que** le moyen de régulation de température (12) comporte une résistance chauffante et/ou un élément à effet Peltier et/ou un moyen d'amenée d'air chaud et/ou un moyen d'amenée de rayonnement infrarouge et/ou de rayonnement micro-onde et/ou un moyen de détente d'air comprimé et/ou un moyen d'amenée d'air froid.

9. Spectromètre RMN selon la revendication 7 ou 8, **caractérisé en ce que** l'au moins un logement de réception (11) comporte au moins une ouverture de régulation de température (12') permettant à l'échantillon de mesure RMN (5) d'accéder au moyen de régulation de température (12) dans le contenant de transport (7).

10. Spectromètre RMN selon la revendication 9, **caractérisé en ce que** le système d'échange (10) comporte au moins une mâchoire de chauffage ou de refroidissement pivotante (12") destinée à réguler la température du contenant de transport (7) pourvu de l'échantillon de mesure RMN (5), la mâchoire de chauffage ou de refroidissement pivotante s'engageant à travers l'ouverture de régulation de température (12') dans une position de régulation de température du logement de réception (11).

11. Spectromètre RMN selon l'une des revendications 7 à 10, **caractérisé en ce qu'**un moyen de régulation électronique (13) est prévu pour réguler la température de l'échantillon de mesure RMN (5) dans le contenant de transport (7) reçu temporairement, de préférence chaque logement de réception (11) comportant son propre moyen de régulation électronique (13).

12. Spectromètre RMN selon la revendication 11, **caractérisé en ce que** le moyen de régulation (13) est conçu pour pouvoir réguler la température de l'échantillon de mesure RMN (5) dans le contenant de transport (7) reçu temporairement suivant un profil de température prédéterminé dans le temps, le profil de température prédéterminé dans le temps étant défini de telle sorte qu'une température souhaitée de l'échantillon de mesure RMN (5) soit atteinte aussi rapidement que possible sans qu'une température maximale prédéterminée ne soit dépassée.

13. Spectromètre RMN selon l'une des revendications précédentes, **caractérisé en ce que** l'échantillon de mesure RMN (5) contient une substance liquide et **en ce que**, pour transporter l'échantillon liquide dans le contenant de transport (7), l'axe du conduit de transport (8) est orienté sensiblement parallèlement à la gravité.

14. Spectromètre RMN selon l'une des revendications précédentes, **caractérisé en ce que** le conduit de transport (8), l'au moins un logement de réception (11) et éventuellement le tube traversant (15) sont de forme cylindrique.

15. Procédé de fonctionnement d'un spectromètre RMN (1) selon l'une des revendications 1 à 14, ledit procédé étant **caractérisé par** les étapes suivantes :
(a) amener un premier contenant de transport (7), venant de l'extérieur et pourvu d'un premier échantillon de mesure RMN (5), à travers le conduit de transport (8) jusque dans le centre magnétique (4) et introduire au moins un autre contenant de transport (7), venant de l'extérieur et pourvu d'un autre échantillon de mesure RMN (5), dans un logement de réception (11) du système d'échange (10) et le recevoir temporairement pendant une durée de réception tp ;
(b) effectuer une mesure RMN sur le premier échantillon de mesure RMN (5) ;
(c) effectuer le transport de retour pneumatique du premier contenant de transport (7), pourvu du premier échantillon de mesure RMN (5), du centre magnétique (4) vers l'extérieur du système magnétique RMN (2) ;
(d) poursuivre le transport pneumatique de l'autre contenant de transport (7), reçu temporairement, du logement de réception (11) du système d'échange (10) au centre magnétique (4).
